(19) Europäisches Patentamt
European Patent Office
Office européen des brevets

(11) EP 1 914 880 A1

(12) EUROPEAN PATENT APPLICATION

(43) Date of publication:
23.04.2008 Bulletin 2008/17

(51) Int Cl.:
H03B 5/04 (2006.01)    H03L 1/02 (2006.01)

(21) Application number: 06122356.6

(22) Date of filing: 16.10.2006

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK RS

(71) Applicant: SiTel Semiconductor B.V.
5215 MV 's-Hertogenbosch (NL)

(72) Inventor: ter Laak, Johan Wilhelm Frederik
6598 BZ, Heijen (NL)

(74) Representative: van Westenbrugge, Andries
Nederlandsch Octrooibureau
Postbus 29720
2502 LS Den Haag (NL)

(54) **Integrated circuit, comprising a voltage controlled oscillator and a method for controlling a temperature of a voltage controlled oscillator**

(57) The invention relates to an integrated circuit, comprising at least a voltage controlled oscillator (VCO) for generating an output signal with an output frequency (f), where the voltage controlled oscillator (VCO) is arranged to be active during an active period, comprising a tuning period and an operation period following the tuning period. During the tuning period the output frequency (f) is tuned to a predetermined value. The integrated circuit further comprises at least one heating element (HE$_1$, HE$_2$, HE$_3$, HE$_4$) arranged to generate a heat flux, and a control unit (CU) arranged to control each at least one heating element (HE$_1$, HE$_2$, HE$_3$, HE$_4$). The control unit (CU) being arranged to control the heat flux generated by each at least one heating element (HE$_1$, HE$_2$, HE$_3$, HE$_4$) during the active period to control a temperature (T$_{VCO}$) of the voltage controlled oscillator (VCO) during the operation period.

## Fig 6

EP 1 914 880 A1

**Description**

TECHNICAL FIELD

The invention relates to an integrated circuit, comprising at least a voltage controlled oscillator for generating an output signal with an output frequency, where the voltage controlled oscillator is arranged to be active during an active period, the active period comprising a tuning period and an operation period following the tuning period, where during the tuning period the output frequency is tuned to a predetermined value. The invention further relates to a telephone device, comprising such an integrated circuit, and a method for controlling a temperature of a voltage controlled oscillator.

STATE OF THE ART

A voltage controlled oscillator is an oscillator that may be tuned over a wide range of frequencies by applying a control voltage (tuning voltage) to it. Basically such a voltage controlled oscillator comprises a capacitance, such as a capacitor, and an inductance that are provided in parallel. The capacitance and the inductance form a resonance element. The voltage controlled oscillator further comprises a current source providing the circuit with energy. This will be described in more detail below.

By adjusting the value of the capacitance, which may be done with a control voltage source, the characteristics of the resonance element may be controlled and consequently, the output frequency of the voltage controlled oscillator. The output frequency may for instance be used as a carrier wave to wirelessly transmit an electro-magnetic signal.

Carrier waves may be used in all sorts of wireless transmission, for instance in the field of wireless or cordless telephones, such as according to the Digital Enhanced Cordless Telecommunications ETSI-standard for digital cordless telephones. The specifications of such cordless telephones are known to a skilled person. It will however be understood that voltage controlled oscillators may be used in many other technical fields, such as in the fields of radio tuners.

In the field of cordless telephones, voltage controlled oscillators may be used to generate a carrier wave of e.g. 1.9 GHz. Of course, the specifications may differ for different applications. In this field the frequency of the carrier wave may not fluctuate much, for instance less than 5 ppm (ppm = part per million).

Voltage controlled oscillators are cheap and may easily be formed as part of an integrated circuit (IC) provided on a semiconductor substrate, such as a silicon substrate. The integrated circuit may be arranged as a transceiver circuit and may also comprise further circuits, such as a digital-analogue converter, filter element, frequency mixer etc. However, voltage controlled oscillators are not very stable and are for instance prone to temperature changes.

Based on the above, it will be understood that a voltage controlled oscillator formed as an integrated circuit provided on a silicon substrate also comprising further circuits may suffer from temperature changes caused by heat generated by these further components. The heat of such further circuits generates a heat flow through the integrated circuit affecting the temperature of the voltage controlled circuit and therefore also the output frequency.

In order to obtain a more stable output frequency it is known in the prior art to provide a feedback loop, in which the temperature of the voltage controlled oscillator is sensed using a sensing element and used to control a heater to compensate the temperature change, for instance by reducing the heat generated by the heater when an increase of the temperature is sensed and increasing the heat generated by the heater when a decrease of the temperature is sensed. However, this solution requires a sensing element and a control loop which makes it a relatively expensive solution that uses relatively much space. Also, such a control loop is relatively slow, i.e. too slow for controlling the temperature of transceiver IC's that operates in a periodic way (slotted with slots of e.g. 0.5 ms). Therefore, it is an object to provide an alternative voltage controlled oscillator that is relatively stable with respect to fluctuations in temperature.

SHORT DESCRIPTION

According to an aspect, there is provided an integrated circuit as defined in the preamble, characterized in, that the integrated circuit further comprises at least one heating element arranged to generate a heat flux, and a control unit arranged to control each at least one heating element, the control unit being arranged to control the heat flux generated by each at least one heating element during the active period to control a temperature of the voltage controlled oscillator during the operation period.

According to an embodiment, the control unit is arranged to control each at least one heating element according to a predetermined control scheme.

According to an embodiment the control unit is arranged to control the temperature of the voltage controlled oscillator to keep the temperature of the voltage controlled oscillator substantially constant during the operation period.

According to an embodiment the integrated circuit further comprises at least one further circuit that, when active, generates a heat flux that influences the temperature of the voltage controlled oscillator.

According to an embodiment each at least one heating element comprises an electrical resistance and a source for providing the electrical resistance with energy.

According to an embodiment the source is one of a voltage source and a current source.

According to an embodiment each at least one heating element comprises a first electrical resistance, a second electrical resistance, a current source for providing the first electrical resistance with energy and a voltage source for providing the second electrical resistance with energy.

According to an embodiment the current source generates a current I and the voltage source generates a voltage V, and the first electrical resistance and the second electrical resistance are substantially chosen according to the following relationship:

$$RE_{i,I} = RE_{i,V} = RE_i = \frac{V^2}{I^2}.$$

According to an embodiment the control unit is arranged to switch on and off each at least one heating element at predetermined moments in time during the active period according to the predetermined control scheme.

According to an embodiment the control unit is arranged to gradually control energy dissipated by the heating elements in time according to the predetermined control scheme.

According to an embodiment the at least one heating element is positioned close to the voltage controlled oscillator, such that the generated heat flux effects the temperature of the voltage controlled oscillator on a time scale $\tau_1$ that is smaller than the duration of the active period.

According to an embodiment the integrated circuit is provided on a semiconductor substrate.

According to an aspect there is provided a telephone device comprising an integrated circuit according to the above.

According to an aspect there is provided a method for controlling a temperature of a voltage controlled oscillator provided as an integrated circuit, the method comprises

- providing an integrated circuit comprising a voltage controlled oscillator for generating an output signal with an output frequency during an active period, the active period comprising a tuning period and an operation period following the tuning period, where during the tuning period the output frequency is tuned to a predetermined value, characterized in, that the method comprises
- providing at least one heating element arranged to generate a heat flux, and
- providing a control unit arranged to control each at least one heating element,
- controlling each at least one heating element during the active period to control a temperature of the voltage controlled oscillator during the operation period.

According to an embodiment controlling each at least one heating element is done according to a predetermined control scheme.

According to an embodiment controlling each at least one heating element during the active period is done to keep the temperature of the voltage controlled oscillator substantially constant during the operation period.

According to an embodiment each at least one heating element comprises an electrical resistance and a source for providing the electrical resistance with energy.

According to an embodiment the source is one of a voltage source and a current source.

According to an embodiment each at least one heating element comprises a first electrical resistance, a second electrical resistance, a current source for providing the first electrical resistance with energy and a voltage source for providing the second electrical resistance with energy.

According to an embodiment the current source generates a current I and the voltage source generates a voltage V, and the first electrical resistance and the second electrical resistance are substantially chosen according to the following relationship:

$$RE_{i,I} = RE_{i,V} = RE_i = \frac{V^2}{I^2}.$$

According to an embodiment controlling each at least one heating element comprises switching on and off each at least one heating element at predetermined moments in time during the active period according to the predetermined control scheme.

According to an embodiment controlling each at least one heating element comprises gradually controlling energy dissipated by the heating elements in time according to the predetermined control scheme.

According to an embodiment providing at least one heating element is done by providing the at least one heating element close to the voltage controlled oscillator, such that the generated heat flux effects the temperature of the voltage controlled oscillator on a time scale $\tau_1$ that is smaller than the duration of the active period.

According to an embodiment providing an integrated circuit is done by providing the integrated circuit on a semiconductor substrate.

SHORT DESCRIPTION OF THE DRAWINGS

Embodiments of the invention will now be described, by way of example only, with reference to the accompanying schematic drawings in which corresponding reference symbols indicate corresponding parts, but are not used to limit the scope of the invention, and in which:

- Figure 1 schematically depicts a voltage controlled oscillator according to the prior art,
- Figure 2 schematically depicts a telephone device according to the prior art,
- Figure 3 schematically depicts a graph showing the active and idle states of a telephone device,
- Figure 4 schematically depicts the output frequency of a voltage controlled oscillator as a function of time,
- Figure 5 schematically depicts the temperature of a voltage controlled oscillator as a function of time,
- Figure 6 schematically depicts a telephone device according to an embodiment,
- Figures 7, 8 and 9 schematically depict heating elements according embodiments.

Same reference numbers used in different figures refer to similar components.

DETAILED DESCRIPTION

First a general description of a voltage controlled oscillator VCO will be given, followed by a description of how such a voltage controlled oscillator may be used in practice.

Voltage controlled oscillator

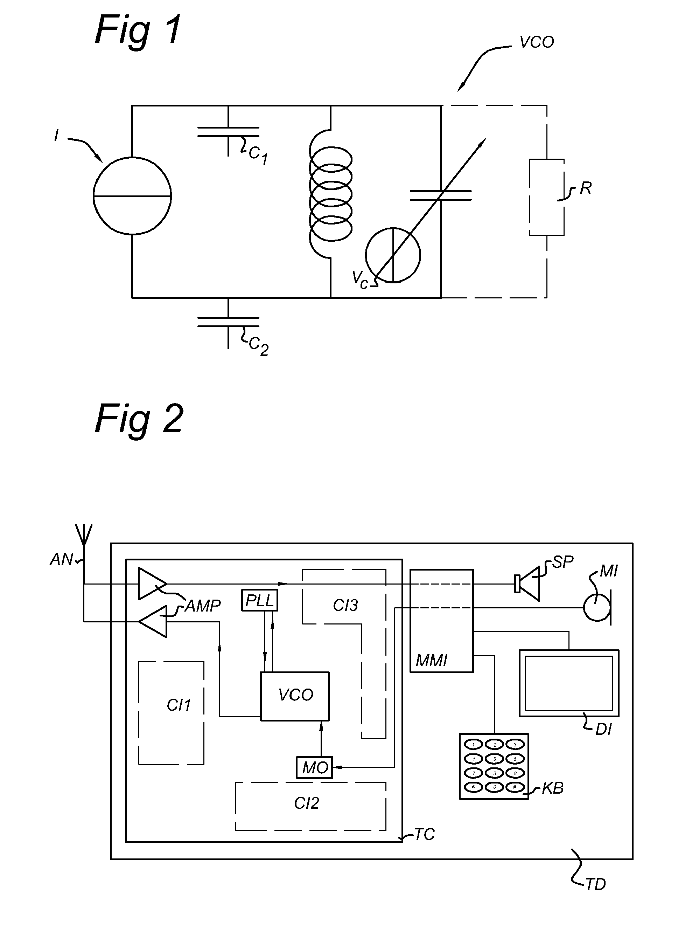

Fig. 1 schematically depicts a model of a voltage controlled oscillator VCO, comprising an inductance L and a capacitance C, provided in parallel. The voltage controlled oscillator VCO further comprises a current source I providing energy to the inductance L and the capacitance C. All elements dissipate energy, which may be modelled with a resistance R (shown in dashed lines).

It is known that such a voltage controlled oscillator VCO generates an output frequency depending on the value of the inductance L and the capacitance C. These may be controlled using a control voltage source $V_c$ providing a control voltage. Such a control voltage source $V_c$ may be used to adjust the value of the capacitance C and as a result, the output frequency of the voltage controlled oscillator VCO.

The dependency of the output frequency f as a function of the inductance L and the capacitance C may be described as:

$$f\left(L, C\left(V_C\right)\right) = \frac{1}{2\pi \sqrt{L C\left(V_C\right)}} \ ,$$

where the capacitance C is, among others, a function of the control voltage $V_C$.

The circuit as described so far may be formed as an integrated circuit, provided on a semi-conductor substrate. Fig. 1 further shows further capacitances $C_1$, $C_2$, depicting the capacitances that may be present between the circuitry as described so far and the underlying semi-conductor substrate. The further capacitances $C_1$, $C_2$ also influence the output frequency f.

The capacitance C and in particular the further capacitances $C_1$, $C_2$ are relatively sensitive for heat generated by further circuits that may be present on the semi-conductor substrate. These further circuits may be any kind of component that may be provided on the semi-conductor substrate.

The value of the capacitances C, $C_1$, $C_2$ will therefore change as a function of temperature. Therefore, the output frequency f is in fact a function of the inductance L, capacitance C and further capacitances $C_1$, $C_2$, where all capacitances $C_i$ are a function of the temperature $T_i$ of that respective capacitance $C_i$:

$$f\left(L, C_i\right) = f\left(L, C_i\left(T_i\right)\right) \ ,$$

where $C_i$ represents one of the capacitance C and the further capacitances $C_1$, $C_2$, and $C_i(T_i)$ is a function of the temperature $T_i$ of that respective capacitance $C_i$. In fact, each capacitance $C_i$ may have a different temperature $T_i$.

It will be understood that the inductance L and the capacitances C, $C_1$, $C_2$ may further be influenced by other parameters than the temperature T, but these dependencies are not considered in this description.

Possible implementation of a voltage controlled oscillator

As stated above, voltage controlled oscillators VCO may be used in many technical fields, such as for instance the field of cordless or portable telephones. When a voltage controlled oscillator VCO is used in the field of cordless or portable telephones, the voltage controlled oscillator VCO may be provided in a telephone device TD as part of transceiver circuit TC formed as an integrated circuit IC on a semi-conductor substrate.

Fig. 2 schematically shows a telephone device TD, comprising such a transceiver circuit TC, arranged to transmit and receive electro-magnetic signals to establish a telephone communication link with a remote party (not shown), such as an other telephone device or a base station.

The telephone device TD further comprises a man-machine interface MMI arranged to communicate with the transceiver circuit TC. The man-machine interface MMI controls the interface between the telephone device TD and a user. The man-machine interface MMI may for instance control a display DI, a keyboard KB, a speaker SP and a microphone MI of the telephone device TD.

It will be understood that the telephone device TD may comprise further hardware elements that are not described here.

The man-machine interface MMI is arranged to receive an analogue microphone signal from the microphone MI, convert this analogue microphone signal to a digital microphone signal and transmit this digital microphone signal to the transceiver circuit TC for transmission. The man-machine interface MMI is further arranged to receive a digital speaker signal from the transceiver circuit TC, convert this digital speaker signal to an analogue speaker signal and transmit this analogue speaker signal to the speaker SP.

The transceiver circuit TC may comprise an antenna AN, an amplifier AMP, a phase locked-loop element PLL, modulator MO and the voltage controlled oscillator VCO. The transceiver circuit TC may also comprise further elements, which are not discussed here. The transceiver circuit TC is arranged to communicate with the man-machine interface MMI. According to an alternative, the modulator MO may be formed as part of the voltage controlled oscillator VCO.

The transceiver circuit TC is arranged to receive the digital microphone signal from the man-machine interface MMI that is to be transmitted to a remote party (not shown) via antenna AN. The digital microphone signal is therefore fed to the modulator MO to modulate the signal using a carrier wave, making the signal suitable for transmission.

The voltage controlled oscillator VCO generates a carrier wave that is fed to the modulator MO. The voltage controlled oscillator VCO may be a voltage controlled oscillator VCO as described above.

When the voltage controlled oscillator VCO is started it needs to be tuned to the appropriate frequency, during a so-called tuning period. This may be done using the phase locked-loop element PLL. The principle of a phase locked-loop is known to a skilled person and is schematically depicted as a box interacting with the voltage controlled oscillator VCO. A phase-locked loop is a closed-loop feedback control system maintaining a generated output signal in a fixed phase relationship to a reference signal. The phase locked-loop element PLL does so by monitoring the output frequency f of the voltage controlled oscillator VCO and controlling the control voltage source $V_c$ described above based on the monitored output frequency f.

The modulator MO is arranged to modulate the received digital microphone signal using the carrier wave to prepare the digital microphone signal for transmission at the required frequency, for instance 1.9 GHz. It will be understood that the modulator MO as depicted in the figures is an example. According to an alternative, the modulator MO may also be formed as part of the voltage controlled oscillator VCO. The modulator MO may control the control voltage source $V_c$ to tune the output frequency of the voltage controlled oscillator VCO to a carrier frequency plus or minus an offset to represent digital values 0 or 1.

The modulator MO may also be positioned downstream of the voltage controlled oscillator VCO to modulate the signal. Such a modulator MO may also be referred to as a mixer.

Before transmitting the signal via antenna AN, the signal may be amplified using amplifier AM.

The transceiver circuit TC is further arranged to receive signals from the remote party, demodulate the received signal and transmit the signals to the man-machine interface MMI.

The transceiver circuit TC may comprise several further circuits CI1, CI2, CI3 as will be understood by a skilled person. Such further circuits CI1, CI2, CI3 may for instance be filters, buffer units, analogue-digital converters and the like. These further circuits CI1, CI2, CI3 are schematically depicted by the dashed lines.

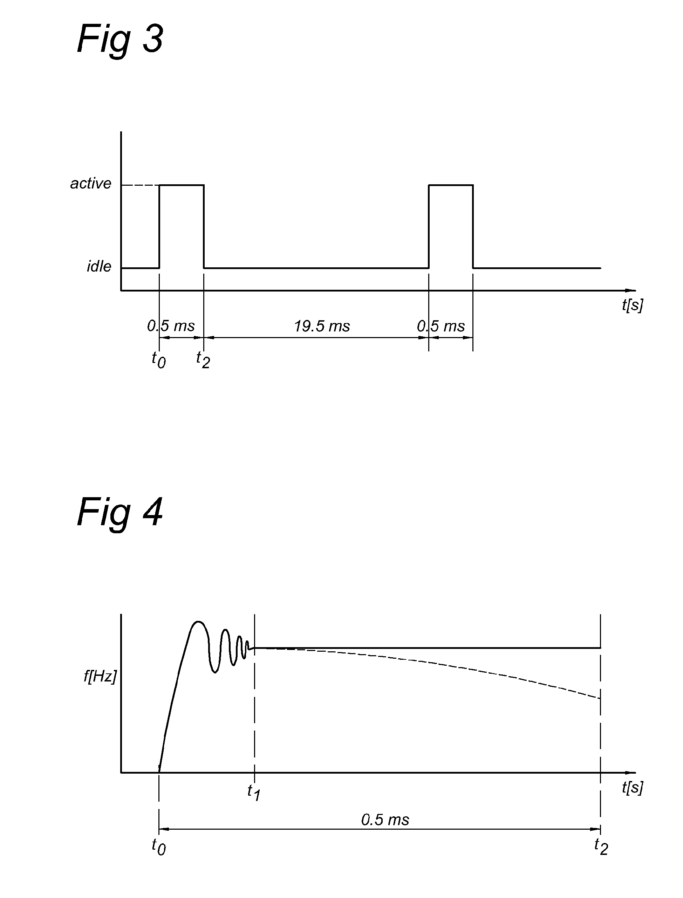

The telephone device TD does not transmit signals constantly, but only does so during relatively small time intervals. The transceiver circuit TC comprising the voltage controlled oscillator VCO is therefore only active during an active period of for instance 0.5 ms followed by an idle period of for instance 19,5 ms. This is schematically depicted in Fig. 3.

During each active period the transceiver circuit TC goes through a similar cycle of activity, in which the voltage controlled oscillator VCO, the modulator MO and the further circuits CI1, CI2, CI3 all play a predetermined role. During the active period the voltage controlled oscillator VCO first is in the tuning period, starting at a time to , in which it is tuned to a predetermined frequency using the phase locked-loop element PLL. The tuning period ends at a time $t_1$. At time $t_1$ the voltage controlled oscillator VCO reaches the predetermined frequency, the PLL is switched off and the voltage controlled oscillator VCO is in an operation period. The operation period is from $t_1$ till $t_2$.

This is schematically depicted in Fig. 4, showing a graph of the output frequency of voltage controlled oscillator VCO as a function of time t.

The reason for switching off the phase locked-loop element PLL may be to be able to modulate the output frequency of the voltage controlled oscillator VCO. After $t_1$, the microphone signal is combined with the carrier wave. If the phase locked-loop element PLL would not be switched off at $t_1$, it would adjust the output of the modulator MO such to cancel the contribution of the microphone signal. As a result, speech information and the like, that is to be transmitted would be lost.

Also, another reason for switching off the phase locked-loop element PLL may be to abtain a better signal to noise ratio. A voltage controlled oscillator VCO in open loop (without the phase locked-loop element PLL) has a better signal to noise ratio compared to a voltage controlled oscillator VCO in closed loop (with the phase locked-loop element PLL), since the voltage controlled oscillator VCO in closed loop is constantly adjusted and controlled by the phase locked-loop element PLL.

After $t_1$, the voltage controlled oscillator VCO is 'free' and fluctuations in the output frequency are possible. According to an ideal situation the frequency remains constant at least for the rest of the active period, as shown in Fig. 4.

However, during the active period the transceiver circuit TC goes through a predetermined cycle in which circuits CI1, CI2, CI3 on the transceiver circuit TC may be switched on and off. All these circuits CI1, CI2, CI3 may heat up and generate a heat flux affecting the temperature T of the voltage controlled oscillator VCO and as a result the output frequency f of the voltage controlled oscillator VCO varies. This effect is schematically depicted in Fig. 4 by the dashed line, showing a slow decrease of the output frequency f of the voltage controlled oscillator VCO.

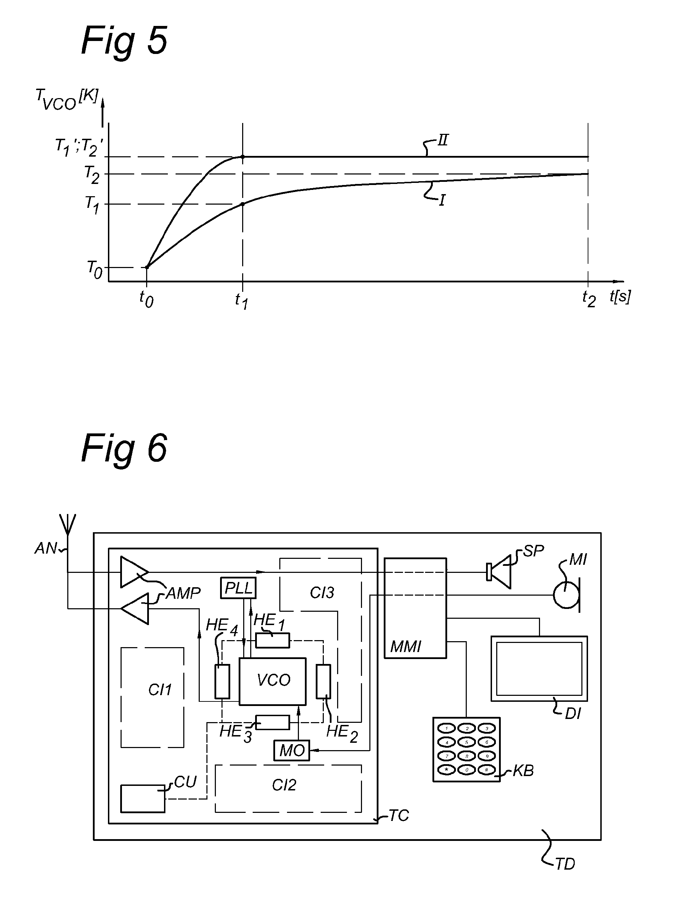

Fig. 5 schematically depicts a temperature curve I showing the temperature $T_{VCO}$ of the voltage controlled oscillator VCO as a function of time t during the active period, from time $t_0$ until $t_2$. At the beginning of the active period at time $t_0$, the temperature $T_0$ is relatively low. From the beginning of the active period until the time $t_1$, at which the output frequency f of the voltage controlled oscillator VCO is settled, the temperature $T_{VCO}$ of the voltage controlled oscillator VCO increases to a temperature $T_1$. However, it can be seen that the temperature $T_{VCO}$ further increases after time $t_1$. This increase may be caused by further circuits CI1, CI2, CI3 that are switched on at some time during the active period and start heating up. This heating of the further circuits CI1, CI2, CI3 will result in heat fluxes heating up the voltage controlled oscillator VCO to a temperature $T_2$, causing the fluctuation of the output frequency f of the voltage controlled oscillator VCO as shown by the dashed line in Fig. 4.

Of course, the voltage controlled oscillator VCO may also cool down as a result of further circuits being switched off during the active period, resulting in a decrease of the temperature $T_{VCO}$ of the voltage controlled oscillator VCO.

In general an increase of the temperature $T_{VCO}$ of the voltage controlled oscillator VCO results in a decrease of the output frequency f, and vice versa.

As described above, after time $t_1$, the phase locked-loop element is no longer active. Therefore, the heating of the voltage controlled oscillator VCO after time $t_1$ will influence the output frequency f as was already shown in Fig. 4.

As already described above, only relatively small fluctuations are allowed to ensure successful transmission to the remote party.

Embodiment 1

According to an embodiment, the voltage controlled oscillator VCO as described with reference to Fig.

's 2 and 3 is made more stable by providing heating elements $HE_1$, $HE_2$, $HE_3$, $HE_4$ at the transceiver circuit TC, as schematically depicted in Fig. 6. Fig. 6 schematically shows the transceiver circuit TC according to Fig. 2, now further comprising the heating elements $HE_1$, $HE_2$, $HE_3$, $HE_4$. The heating elements $HE_1$, $HE_2$, $HE_3$, $HE_4$ are positioned near the voltage controlled oscillator VCO and are capable of generating a heat flux that heats up the voltage controlled oscillator VCO. The heating elements $HE_1$, $HE_2$, $HE_3$, $HE_4$ are controlled by a control unit CU.

The control unit CU is arranged to control each at least one heating element according to a predetermined control scheme. This can be done, since the temperature effects of the further circuits CI1, CI2, CI3 and the like are known beforehand. This allows controlling the heating elements $HE_1$, $HE_2$, $HE_3$, $HE_4$ according to a predetermined control scheme. This control scheme may for instance define predetermined moments in time during the active period at which the control unit switches on and off certain heating elements $HE_1$, $HE_2$, $HE_3$, $HE_4$.

The power that is dissipated by the heating elements $HE_1$, $HE_2$, $HE_3$, $HE_4$ may be controlled in time by a programmable setting executed by the control unit CU, chosen such that it cancels the heat flux coming from the further circuits CI1, CI2, CI3 after time $t_1$. The heating elements $HE_1$, $HE_2$, $HE_3$, $HE_4$ may be switched on and switched off during the active period of the transceiver circuit TC at predetermined moments in time, controlled by the control unit CU.

By turning on the heating elements $HE_1$, $HE_2$, $HE_3$, $HE_4$ at the beginning of the active period, the temperature T of the voltage controlled oscillator VCO will increase more rapidly in between time to and $t_1$, i.e. the period in which the voltage controlled oscillator VCO is tuned and settles. This is shown in Fig. 5 with temperature curve II. In between time $t_0$ and $t_1$ the temperature of the voltage controlled oscillator VCO will increase from the initial temperature $T_o$ to a temperature $T_1$'. As a result of the heat generated by the heating elements $HE_1$, $HE_2$, $HE_3$, $HE_4$ the temperature $T_1$' at time $t_1$ is higher than the temperature $T_1$ at time $t_1$ of temperature curve I, in which no heating elements $HE_1$, $HE_2$, $HE_3$, $HE_4$ were used.

After time $t_1$, the voltage controlled oscillator VCO is 'free', it is no longer controlled by the phase locked-loop element PLL (during the operation period). As seen in the example above, the temperature $T_{VCO}$ of the voltage controlled oscillator VCO will rise as a result of heat coming from further circuits CI1, CI2, CI3 that are switched on at some time during the active period and start heating up. However, according to this embodiment, this increase in temperature is counteracted by switching off the heating elements $HE_1$, $HE_2$, $HE_3$, $HE_4$.

As a result, the temperature $T_{VCO}$ of the voltage controlled oscillator VCO remains relatively stable. At time $t_2$ the temperature $T_2$'of the voltage controlled oscillator VCO substantially equals the temperature $T_1$' of the voltage controlled oscillator VCO at time $t_1$.

It can be seen that $T_2'$ may be higher than $T_2$. Thus, according to the embodiments described here, the voltage controlled oscillator VCO is actually set at a higher temperature. However, this higher temperature is substantially settled before the phase-locked loop element PLL is switched off.

It will be understood that the heating elements $HE_1$, $HE_2$, $HE_3$, $HE_4$ may be positioned relatively close to the voltage controlled oscillator VCO to ensure that the heat flux generated by these heating elements $HE_1$, $HE_2$, $HE_3$, $HE_4$ reaches the voltage controlled oscillator VCO before time $t_1$ and the temperature $T_{VCO}$ of the voltage controlled oscillator VCO may be settled at time $t_1$. This way the temperature effect of the heating elements $HE_1$, $HE_2$, $HE_3$, $HE_4$ is settled at time $t_1$ and no substantial heat fluctuations of the voltage controlled oscillator VCO occur after time $t_1$ as a result of a heat flux generated by the heating elements $HE_1$, $HE_2$, $HE_3$, $HE_4$.

The heating elements $HE_1$, $HE_2$, $HE_3$, $HE_4$ are controlled by control unit CU in such a way that they are switched on and off at predetermined moments in time during the active period, for instance sometime between $t_1$ and $t_2$.

In the example shown in Fig. 5 by temperature curve I (without the heating elements $HE_1$, $HE_2$, $HE_3$, $HE_4$), after $t_1$ the temperature $T_{VCO}$ of the voltage controlled oscillator VCO shows a constant rise. According to this example it may be optimal to switch on the heating elements $HE_1$, $HE_2$, $HE_3$, $HE_4$ at time to and switch off the heating elements $HE_1$, $HE_2$, $HE_3$, $HE_4$ at constant time intervals in between time $t_1$ and $t_2$ to gradually compensate this rise in temperature.

However, in case it is observed that the temperature $T_{VCO}$ of the voltage controlled oscillator VCO rises more strongly in a first period after time $t_1$ and rises less strongly or even remains constant in a second period approaching time $t_2$ (without the heating elements $HE_1$, $HE_2$, $HE_3$, $HE_4$) the first three heating elements $HE_1$, $HE_2$, $HE_3$ may be switched off at relatively short time intervals after $t_1$, and the time interval in between switching off the third heating element $HE_3$ and the fourth heating element $HE_4$ may be relatively longer.

Since the transceiver circuit TC goes through a similar cycle of procedures during each active period, the temperature $T_{VCO}$ of the voltage controlled oscillator VCO also experiences a similar temperature cycle during each active period. This temperature cycle of the voltage controlled oscillator VCO may be observed during the manufacturing process of the transceiver circuit TC and may for instance result in temperature curve I as shown in Fig. 5 (without heating elements). However, it will be understood that temperature curve I may be less smooth and may show bumps and the like resulting from the abrupt switching on or off of one or more further circuits CI1, CI2, CI3.

Based on the observed temperature curve I, or an observed curve of the output frequency f of the voltage controlled oscillator VCO, the timing of switching on and off the heating elements $HE_1$, $HE_2$, $HE_3$, $HE_4$ may be determined. This timing may be programmed and executed by the transceiver circuit TC using control unit CU. It will be understood that any kind of control unit CU may be used for this.

The control unit CU may be a dedicated piece of hardware, or may be a processor arranged to read and execute programming lines from memory (not shown). The control unit CU may further be arranged to control further elements on the transceiver circuit TC.

Of course, the moments in time the heating elements $HE_1$, $HE_2$, $HE_3$, $HE_4$ are switched on may also be determined based on the observed temperature curve I. In fact, it may be the case that the observed temperature $T_{VCO}$ of the voltage controlled oscillator VCO without using heating elements $HE_1$, $HE_2$, $HE_3$, $HE_4$ descends at a certain moment in time, as a result of certain further circuits CI being switched off. In such a case, the heating elements $HE_1$, $HE_2$, $HE_3$, $HE_4$ may be switched on at a predetermined moment in time in between to and $t_2$.

In the embodiment depicted in Fig. 6 four heating elements $HE_1$, $HE_2$, $HE_3$, $HE_4$ are provided. However, it will be understood that any suitable number of heating elements $HE_1$, $HE_2$, $HE_3$, $HE_4$ may be provided, such as one, two, three, five or more heating elements $HE_i$. The amount of heating elements $HE_1$, $HE_2$, $HE_3$, $HE_4$ may be chosen based on experiments done with the transceiver circuit TC without heating elements.

Since the heating elements $HE_1$, $HE_2$, $HE_3$, $HE_4$ are relatively small and located close to the voltage controlled oscillator VCO the switching on and off affects the voltage controlled oscillator VCO on a first small time scale $\tau_1$.

The heating elements $HE_1$, $HE_2$, $HE_3$, $HE_4$ may be positioned close to the voltage controlled oscillator VCO, in such a way that the generated heat flux affects the temperature $T_{VCO}$ of the voltage controlled oscillator VCO on a time scale $\tau_1$ that is smaller than the duration of the active period. This allows quick control of the temperature of the $T_{VCO}$ of the voltage controlled oscillator VCO, within the available time window, i.e. the active period.

The further circuits CI1, CI2, CI3 have bigger dimensions than the heating elements $HE_1$, $HE_2$, $HE_3$, $HE_4$, and are located further away than the voltage controlled oscillator VCO. Therefore, the effect of switching on and off these further circuits CI1, CI2, CI3 on voltage controlled oscillator VCO have a second time scale $\tau_2$ associated with it that is larger than the first time scale $\tau_1$ of the heating elements $HE_1$, $HE_2$, $HE_3$, $HE_4$: $\tau_1 < \tau_2$.

It will be understood that the time scale $\tau$ may be defined in many ways. According to an example, $\tau$ may be a fitting parameter used to describe the temperature $T_{VCO}(t)$ of the voltage controlled oscillator VCO as a function of time t, when one of the heating elements $HE_1$, $HE_2$, $HE_3$, $HE_4$ is switched on. The temperature T(t) may be defined:

$$T_{VCO}\left(t\right) = T_{start} + \left(T_{settled} - T_{start}\right)\left(1 - e^{-\left(\frac{t}{\tau}\right)}\right),$$

where $T_{start}$ is the temperature of the voltage controlled oscillator VCO at time t = 0, i.e. at the moment the heating element is switched on, and $T_{settled}$ is the temperature at which the temperature of the voltage controlled oscillator VCO would settle at time t →∞.

This difference in time scale is accounted for by using more than one heating element $HE_1$, $HE_2$, $HE_3$, $HE_4$, that are switched on and off at different moments in time to allow control of the temperature TVCO of the voltage controlled oscillator VCO during a time scale larger than the first time scale $\tau_1$.

Also the position of the heating elements $HE_1$, $HE_2$, $HE_3$, $HE_4$ may be chosen differently from the embodiment shown in Fig. 6. The heating elements $HE_1$, $HE_2$, $HE_3$, $HE_4$ may be positioned in a symmetrical way around the voltage controlled oscillator VCO, but the positions of the heating elements $HE_1$, $HE_2$, $HE_3$, $HE_4$ may also be positioned depending on the further circuits CI1, CI2, CI3 in order to compensate the heat fluxes of the further circuits CI1, CI2, CI3 in an optimal way.

It will further be understood that the heating elements $HE_1$, $HE_2$, $HE_3$, $HE_4$ may all be similar to each other, or may be different elements, i.e. producing different heat fluxes. The characteristics of the heating elements $HE_1$, $HE_2$, $HE_3$, $HE_4$ may be chosen depending on the further circuits CI1, CI2, CI3 in order to compensate the heat fluxes of the further circuits CI1, CI2, CI3 in an optimal way.

Heating elements

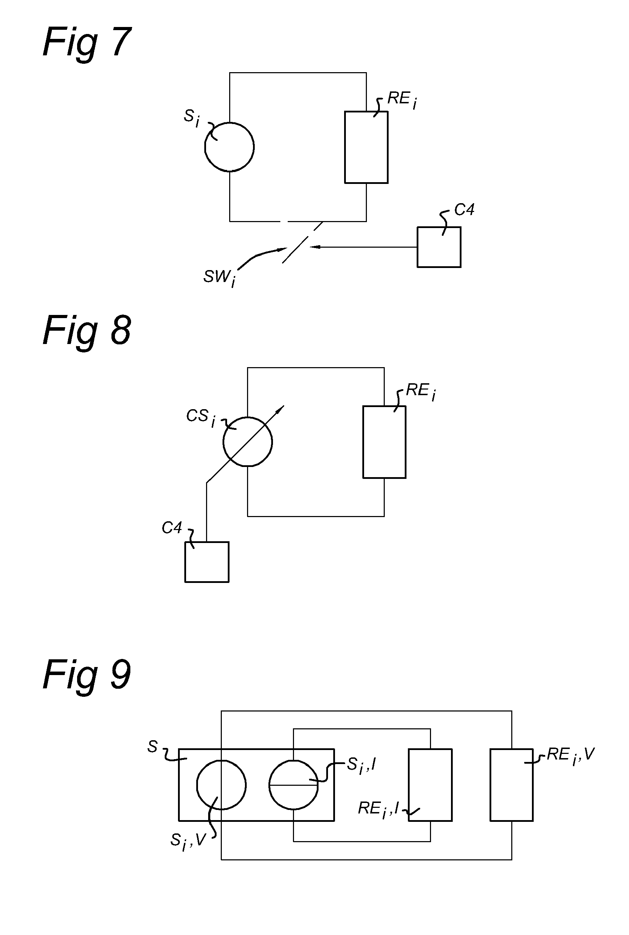

The heating elements $HE_1$, $HE_2$, $HE_3$, $HE_4$ may be formed in any suitable way. According to an embodiment, the heating elements $HE_1$, $HE_2$, $HE_3$, $HE_4$ are formed by a simple electrical resistance $RE_i$ that is connected to a source S;, such as a voltage source or a current source, where i = 1, 2, 3, .... This is schematically shown in Fig. 7, showing a single heating element HE;. It will be understood that each heating element $HE_i$ may be formed like this. All heating elements $HE_1$, $HE_2$, $HE_3$, $HE_4$ may have its own source $S_i$. Alternatively, all heating elements $HE_i$ may be fed by one common source S.

The heating elements $HE_1$, $HE_2$, $HE_3$, $HE_4$ may further comprise a controllable switch $SW_i$ to switch the heating element on and off. The switch $SW_i$ may be controlled by control unit CU.

The power dissipated (amount of energy dissipated per second) $P_i$ by the electrical resistance $RE_i$ can be computed. In case the electrical resistance $RE_i$ is fed by a voltage source, the dissipated power equals:

$$P_{i,V} = \frac{V^2}{RE_i},$$

where V represents the voltage applied to the electrical resistance $RE_i$.

In case the electrical resistance $RE_i$ is fed by a current source, the dissipated power equals:

$$P_{i,I} = I^2 RE_i,$$

where I represents the current applied to the electrical resistance $RE_i$.

Embodiment 2

According to a further embodiment, the energy dissipated by the heating elements $HE_1$, $HE_2$, $HE_3$, $HE_4$ is controlled in time, to allow an even better control of the temperature $T_{VCO}$ of the voltage controlled oscillator VCO. This may be achieved by providing heating elements $HE_1$, $HE_2$, $HE_3$, $HE_4$ as shown in Fig. 8. According to the example shown in Fig. 8, the source is now provided by a controllable source $CS_i$, which is connected to and controlled by the control unit CU. By adjusting the amount of energy provided by the controllable source $CS_i$, the heat flux generated by the heating elements $HE_1$, $HE_2$, $HE_3$, $HE_4$ may be controlled and adjusted during the active period, to allow even better compensation of temperature fluctuations as observed in the voltage controlled oscillator VCO as tested without heating elements $HE_1$, $HE_2$, $HE_3$, $HE_4$.

By gradually decreasing the power dissipated by the heating elements $HE_1$, $HE_2$, $HE_3$, $HE_4$ the time scale $\tau_1$ associated with the heat influence of the heating elements $HE_1$, $HE_2$, $HE_3$, $HE_4$ on the voltage controlled oscillator VCO may be increased. In stead of an abrupt switch off of the heating elements $HE_1$, $HE_2$, $HE_3$, $HE_4$ it is now possible to switch them off gradually, resulting in a gradual decrease of the heat flux from the heating elements $HE_1$, $HE_2$, $HE_3$, $HE_4$ to the voltage controlled oscillator VCO.

Embodiment 3

It is known that the value of an electrical resistance $RE_i$ is not very precise and may differ between different batches of electrical resistances. In fact, an electrical resistance $RE_i$ may have an actual resistance value that differs from the value indicated by the manufacturer by up to 20%. This may result in unpredictable heat fluxes generated by the heating elements $HE_1$, $HE_2$, $HE_3$, $HE_4$, causing inaccurate control of the temperature $T_{VCO}$ of the voltage controlled oscillator VCO. However, electrical resistances from a single batch may be assumed to be substantial similar.

Therefore, according to a further embodiment, the heating elements $HE_1$, $HE_2$, $HE_3$, $HE_4$ may be formed as shown in Fig. 9, having a source S comprising a current source $S_{i,I}$ and a voltage source $S_{i,V}$, a first electrical resistance $RE_{i,I}$ being fed by the current source $S_{i,I}$ and a second electrical resistance $RE_{i,V}$ being fed by the voltage source $S_{i,V}$. Both the first electrical resistance $RE_{i,I}$ and the second electrical resistance $RE_{i,V}$ are from the same batch and are assumed to be substantially equal to each other, and will be denoted with $RE_i$ below. The total amount of power $P_{tot}$ dissipated equals:

$$P_{tot} = P_{i,V} + P_{i,I} = \frac{V^2}{RE_i} + I^2 RE_i .$$

Based on the above it will be understood that the actual value of the electrical resistance $RE_i$ may be inaccurate by up to 20%. However, it can be shown that the amount of power $P_{tot}$ is relatively insensitive with respect to fluctuations of the electrical resistance $RE_i$, as the derivative as the total electrical resistance $P_{tot}$ to the electrical resistance $RE_i$ equals:

$$\frac{\partial P_{tot}}{\partial RE_i} = -\frac{V^2}{RE_i^2} + I^2 .$$

It can be seen that in case the value of the electrical resistance $RE_i$ is high compared to the specification of the manufacturer, this results in a decrease of the power dissipated by the electrical resistance $RE_i$ fed by the voltage source, and an increase of the power dissipated by the electrical resistance $RE_i$ fed by the current source. These two contributions cancel each other at least partially. It can be seen that in case $RE_i$ is chosen as follows

$$RE_{i,I} = RE_{i,V} = RE_i = \frac{V^2}{I^2} ,$$

fluctuations of the electrical resistance $RE_i$ result in fluctuations in the power dissipated by the first electrical resistance $RE_{i,I}$ and the second electrical resistance $RE_{i,V}$ that are opposite and are substantially of the same magnitude, and therefore substantially cancel each other.

The descriptions above are intended to be illustrative, not limiting. Thus, it will be apparent to one skilled in the art that modifications may be made to the invention as described without departing from its scope as defined by the claims set out below, and their technical equivalences.

**Claims**

1. Integrated circuit, comprising at least a voltage controlled oscillator (VCO) for generating an output signal with an output frequency (f), where the voltage controlled oscillator (VCO) is arranged to be active during an active period, the active period comprising a tuning period and an operation period following the tuning period, where during the tuning period the output frequency (f) is tuned to a predetermined value, **characterized in, that** the integrated circuit further comprises at least one heating element ($HE_1$, $HE_2$, $HE_3$, $HE_4$) arranged to generate a heat flux, and a control unit (CU) arranged to control each at least one heating element ($HE_1$, $HE_2$, $HE_3$, $HE_4$), the control unit (CU) being arranged to control the heat flux generated by each at least one heating element ($HE_1$, $HE_2$, $HE_3$, $HE_4$) during the active period to control a temperature ($T_{VCO}$ of the voltage controlled oscillator (VCO) during the operation period.

2. Integrated circuit according to claim 1, wherein the control unit (CU) is arranged to control each at least one heating element ($HE_1$, $HE_2$, $HE_3$, $HE_4$) according to a predetermined control scheme.

3. Integrated circuit according to any one of the claims 1-2, where the control unit (CU) is arranged to control the temperature ($T_{VCO}$) of the voltage controlled oscillator (VCO) to keep the temperature ($T_{VCO}$) of the voltage controlled oscillator (VCO) substantially constant during the operation period.

4. Integrated circuit according to any one of the preceding claims, the integrated circuit further comprising at least one further circuit (CI1, CI2, CI3) that, when active, generates a heat flux that influences the temperature ($T_{VCO}$) of the voltage controlled oscillator (VCO).

5. Integrated circuit according to any one of the preceding claims, wherein each at least one heating element ($HE_1$, $HE_2$, $HE_3$, $HE_4$) comprises an electrical resistance ($RE_i$) and a source ($S_i$) for providing the electrical resistance ($RE_i$) with energy.

6. Integrated circuit according to claim 5, wherein the source ($S_i$) is one of a voltage source and a current source.

7. Integrated circuit according to any one of the claims 5-6, wherein each at least one heating element ($HE_1$, $HE_2$, $HE_3$, $HE_4$) comprises a first electrical resistance ($RE_{i,I}$), a second electrical resistance ($RE_{i,V}$),

a current source ($S_{i,I}$) for providing the first electrical resistance ($RE_{i,I}$) with energy and a voltage source ($S_{i,V}$) for providing the second electrical resistance ($RE_{i,V}$) with energy.

8. Integrated circuit according to claim 7, where the current source ($S_{i,I}$) generates a current I and the voltage source ($S_{i,V}$) generates a voltage V, and the first electrical resistance ($RE_{i,I}$) and the second electrical resistance ($RE_{i,V}$) are substantially chosen according to the following relationship:

$$RE_{i,I} = RE_{i,V} = RE_i = \frac{V^2}{I^2}.$$

9. Integrated circuit according to any one of the claims 2 - 8, wherein the control unit (CU) is arranged to switch on and off each at least one heating element ($HE_1$, $HE_2$, $HE_3$, $HE_4$) at predetermined moments in time during the active period according to the predetermined control scheme.

10. Integrated circuit according to any one of the claims 2-9, wherein the control unit (CU) is arranged to gradually control energy dissipated by the heating elements $HE_1$, $HE_2$, $HE_3$, $HE_4$ in time according to the predetermined control scheme.

11. Integrated circuit according to any one of the preceding claims, where the at least one heating element ($HE_1$, $HE_2$, $HE_3$, $HE_4$) is positioned close to the voltage controlled oscillator (VCO), such that the generated heat flux effects the temperature ($T_{VCO}$) of the voltage controlled oscillator (VCO) on a time scale $\tau_1$ that is smaller than the duration of the active period.

12. Integrated circuit according to any one of the preceding claims, where the integrated circuit is provided on a semiconductor substrate.

13. Telephone device comprising an integrated circuit according to any one of the claims 1 - 12.

14. Method for controlling a temperature ($T_{VCO}$) of a voltage controlled oscillator (VCO) provided as an integrated circuit, the method comprises

 - providing an integrated circuit comprising a voltage controlled oscillator (VCO) for generating an output signal with an output frequency (f) during an active period, the active period comprising a tuning period and an operation period following the tuning period, where during the tuning period the output frequency (f) is tuned to a predetermined value,

**characterized in, that** the method comprises

 - providing at least one heating element ($HE_1$, $HE_2$, $HE_3$, $HE_4$) arranged to generate a heat flux, and
 - providing a control unit (CU) arranged to control each at least one heating element ($HE_1$, $HE_2$, $HE_3$, $HE_4$),
 - controlling each at least one heating element ($HE_1$, $HE_2$, $HE_3$, $HE_4$) during the active period to control a temperature ($T_{VCO}$) of the voltage controlled oscillator (VCO) during the operation period.

15. Method according to claim 14, wherein controlling each at least one heating element ($HE_1$, $HE_2$, $HE_3$, $HE_4$) is done according to a predetermined control scheme.

16. Method according to any one of the claims 14 - 15, where controlling each at least one heating element ($HE_1$, $HE_2$, $HE_3$, $HE_4$) during the active period is done to keep the temperature ($T_{VCO}$) of the voltage controlled oscillator (VCO) substantially constant during the operation period.

17. Method according to any one of the claims 14 - 16, wherein each at least one heating element ($HE_1$, $HE_2$, $HE_3$, $HE_4$) comprises an electrical resistance ($RE_i$) and a source ($S_i$) for providing the electrical resistance ($RE_i$) with energy.

18. Method according to claim 17, wherein the source ($S_i$) is one of a voltage source and a current source.

19. Method according to any one of the claims 17 - 18, wherein each at least one heating element ($HE_1$, $HE_2$, $HE_3$, $HE_4$) comprises a first electrical resistance ($RE_{i,I}$), a second electrical resistance ($RE_{i,V}$), a current source ($S_{i,I}$) for providing the first electrical resistance ($RE_{i,I}$) with energy and a voltage source ($S_{i,V}$) for providing the second electrical resistance ($RE_{i,V}$) with energy.

20. Method according to claim 19, where the current source ($S_{i,I}$) generates a current I and the voltage source ($S_{i,V}$) generates a voltage V, and the first electrical resistance ($RE_{i,I}$) and the second electrical resistance ($RE_{i,V}$) are substantially chosen according to the following relationship:

$$RE_{i,I} = RE_{i,V} = RE_i = \frac{V^2}{I^2}.$$

**21.** Method according to any one of the claims 15 - 20, wherein controlling each at least one heating element ($HE_1$, $HE_2$, $HE_3$, $HE_4$) comprises switching on and off each at least one heating element ($HE_1$, $HE_2$, $HE_3$, $HE_4$) at predetermined moments in time during the active period according to the predetermined control scheme.

**22.** Method according to any one of the claims 15 - 21, wherein controlling each at least one heating element ($HE_1$, $HE_2$, $HE_3$, $HE_4$) comprises gradually controlling energy dissipated by the heating elements ($HE_1$, $HE_2$, $HE_3$, $HE_4$) in time according to the predetermined control scheme.

**23.** Method according to any one of the claims 14 - 22, wherein providing at least one heating element ($HE_1$, $HE_2$, $HE_3$, $HE_4$) is done by providing the at least one heating element ($HE_1$, $HE_2$, $HE_3$, $HE_4$) close to the voltage controlled oscillator (VCO), such that the generated heat flux effects the temperature ($T_{VCO}$) of the voltage controlled oscillator (VCO) on a time scale $\tau_1$ that is smaller than the duration of the active period.

**24.** Method according to any one of the claims 14 - 23, where providing an integrated circuit is done by providing the integrated circuit on a semiconductor substrate.

# Fig 1

# Fig 2

# Fig 3

# Fig 4

## Fig 5

## Fig 6

## Fig 7

## Fig 8

## Fig 9

**European Patent Office**

## EUROPEAN SEARCH REPORT

| Application Number |
| --- |
| EP 06 12 2356 |

### DOCUMENTS CONSIDERED TO BE RELEVANT

| Category | Citation of document with indication, where appropriate, of relevant passages | Relevant to claim | CLASSIFICATION OF THE APPLICATION (IPC) |
| --- | --- | --- | --- |
| X | EP 1 411 630 A (MARVELL SEMICONDUCTOR INC [US]) 21 April 2004 (2004-04-21) * paragraph [0030] - paragraph [0034]; figures 4,10 * ----- | 1-24 | INV. H03B5/04 H03L1/02 |
| X | US 2003/034851 A1 (NORMAN ROBERT D [US] ET AL) 20 February 2003 (2003-02-20) * paragraphs [0007], [0009], [0015], [0020], [0030]; figure 1 * ----- | 1-24 | |
| X | US 4 497 998 A (WEST BURNELL G [US]) 5 February 1985 (1985-02-05) * the whole document * ----- | 1-24 | |
| A | WO 96/17389 A (ADVANTEST CORP [JP]; ADVANTEST AMERICA INC [US]; SATO MASATOSHI [JP];) 6 June 1996 (1996-06-06) * abstract; figures 1,2 * ----- | 1-24 | |
| | | | **TECHNICAL FIELDS SEARCHED (IPC)** |
| | | | H03B H03K H03L |

The present search report has been drawn up for all claims

| Place of search | Date of completion of the search | Examiner |
| --- | --- | --- |
| The Hague | 28 March 2007 | BEASLEY-SUFFOLK, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 12 2356

This annex lists the patent family members relating to the patent documents cited in the above-mentioned European search report.
The members are as contained in the European Patent Office EDP file on
The European Patent Office is in no way liable for these particulars which are merely given for the purpose of information.

28-03-2007

| Patent document cited in search report | | Publication date | Patent family member(s) | | Publication date |
|---|---|---|---|---|---|
| EP 1411630 | A | 21-04-2004 | CN | 1497835 A | 19-05-2004 |
| | | | JP | 2004201280 A | 15-07-2004 |
| | | | US | 2004071029 A1 | 15-04-2004 |
| | | | US | 2004246809 A1 | 09-12-2004 |
| US 2003034851 | A1 | 20-02-2003 | US | 2005104674 A1 | 19-05-2005 |
| US 4497998 | A | 05-02-1985 | JP | 59122112 A | 14-07-1984 |
| WO 9617389 | A | 06-06-1996 | DE | 4481362 T0 | 16-10-1997 |
| | | | US | 5886564 A | 23-03-1999 |

EPO FORM P0459

For more details about this annex : see Official Journal of the European Patent Office, No. 12/82